# EUROPEAN PATENT SPECIFICATION

(11) **EP 3 701 569 B1**
(45) Date of publication and mention of the grant of the patent: **22.10.2025**
(21) Application number: 18847202.1
(22) Date of filing: 14.05.2018
(51) Int. Cl.: H10K 59/124, H10D 30/67, H10D 86/40, H10D 86/60, G02F 1/1362, G02F 1/1368

(54) **THIN FILM TRANSISTOR, ARRAY SUBSTRATE, FABRICATING METHODS THEREOF, AND DISPLAY APPARATUS**
DÜNNSCHICHTTRANSISTOR, ARRAY-SUBSTRAT, HERSTELLUNGSVERFAHREN DAFÜR UND ANZEIGEVORRICHTUNG
TRANSISTOR À COUCHES MINCES, SUBSTRAT DE RÉSEAU, LEURS PROCÉDÉS DE FABRICATION ET APPAREIL D'AFFICHAGE

(30) Priority: 26.10.2017 CN 201711013826
(43) Date of publication of application: 02.09.2020
(73) Proprietor: BOE Technology Group Co., Ltd., Beijing 100015 (CN); Ordos Yuansheng Optoelectronics Co., Ltd., Ordos, Inner Mongolia 017020 (CN)
(72) Inventor: LI, Lei, Beijing 100176 (CN); FAN, Jun, Beijing 100176 (CN); LI, Fuqiang, Beijing 100176 (CN); LIU, Taiyang, Beijing 100176 (CN)
(74) Representative: Cohausz & Florack
(86) International application number: PCT/CN2018/086710
(87) International publication number: WO 2019/080480

(56) References cited:
- CN-A- 106 158 882
- CN-A- 107 611 181
- CN-U- 207 303 112
- US-A- 5 834 344
- US-A1- 2001 022 365
- US-A1- 2011 147 750
- US-A1- 2013 300 968

## Description

### CROSS-REFERENCE TO RELATED APPLICATIONS

This application claims benefit of the filing date of Chinese Patent Application No. 201711013826.1 filed on October 26, 2017.

### TECHNICAL FIELD

This disclosure relates to a display technology, and more particularly, to a thin film transistor, an array substrate, fabricating methods thereof, and a display apparatus.

### BACKGROUND

With the development of display technology, various products with display function such as mobile phones, tablet computers, televisions, laptops, digital photo frames, navigation devices, virtual reality (VR) products appear in daily life. These products all need to install a display panel.

At present, most display panels include an array substrate, a color filter substrate, and a liquid crystal layer between the array substrate and the color filter substrate. The array substrate includes a base substrate and a plurality of thin film transistors (TFTs) arranged in an array on the base substrate. For VR products, in order not to affect the 3D display effect of VR, it is necessary to increase the number of pixels per inch (PPI) on the array substrate. By reducing the distance between the source and the drain in the TFT, the size of the pixel can be further reduced so that the PPI of the array substrate can be improved. However, if the distance between the source and the drain in the TFT is too small, when the source and the drain are formed, the source and the drain are easily short-circuited, resulting in short-circuiting of the corresponding TFT. As a result, the resulting TFT is prone to be defective.

US2011/0147750 A1, US2001/033365 A1, US5,834,344 and CN 106158882 A disclose array susbtrates.

### BRIEF SUMMARY

Accordingly, one example of the present disclosure is a thin film transistor. The thin film transistor includes a gate pattern, an active layer pattern, a gate insulating layer between the gate pattern and the active layer pattern, a first conductive pattern comprising a first pattern part and a first connecting part, a second conductive pattern comprising a second pattern part and a second connecting part, and a first intermediate insulating layer between the first pattern part and the second pattern part. The first conductive pattern and the second conductive pattern are a source pattern and a drain pattern, respectively, a first through hole is provided on the first intermediate insulating layer, and the second conductive pattern is connected to the active layer pattern through the second connecting part in the first through hole.

The thin film transistor may further include a second intermediate insulating layer. The active layer pattern, the gate insulating layer, the gate pattern, the second intermediate insulating layer, the first conductive pattern, the first intermediate insulating layer, and the second conductive pattern may be sequentially stacked. A second through hole and a third through hole may be provided on the second intermediate insulating layer, the first conductive pattern may be connected to the active layer pattern through the first connecting part in the second through hole, and the second conductive pattern may be connected to the active layer pattern through the first connecting part sequentially in the first through hole and the third through hole.

A fourth through hole and a fifth through hole may be provided on the gate insulating layer, the first conductive pattern may be connected to the active layer pattern sequentially through the first connecting part in the second through hole and the fourth through hole, and the second conductive pattern may be connected to the active layer pattern through the second connecting part sequentially in the first through hole, the third through hole, and the fifth through hole. The gate pattern, the gate insulating layer, the active layer pattern, the first conductive pattern, the first intermediate insulating layer, and the second conductive pattern may be sequentially stacked.

Another embodiment of the present disclosure is a method of fabricating a thin film transistor. The method of fabricating a thin film transistor includes forming a gate pattern, an active layer pattern, a gate insulating layer, a first conductive pattern comprising a first pattern part and a first connecting part, a second conductive pattern comprising a second pattern part and a second connecting part, and a first intermediate insulating layer on a base substrate. The gate insulating layer is between the gate pattern and the active layer pattern, and the first intermediate insulating layer is between the first pattern part and the second pattern part. The first conductive pattern and the second conductive pattern are a source pattern and a drain pattern, respectively. A first through hole is provided on the first intermediate insulating layer, and the second conductive pattern is connected to the active layer pattern through the second connecting part in the first through hole.

In some embodiments, forming the gate pattern, the active layer pattern, the gate insulating layer, the first conductive pattern, the second conductive pattern, and the first intermediate insulating layer on the base substrate may include forming the active layer pattern, the gate insulating layer, the gate pattern, the second intermediate insulating layer, the first conductive pattern, the first intermediate insulating layer, and the second conductive pattern sequentially on the base substrate. A second through hole and a third through hole may be provided on the second intermediate insulating layer, the first conductive pattern may be connected to the active layer pattern through the first connecting part in the second through hole, and the second conductive pattern may be connected to the active layer pattern through the second connecting part sequentially in the first through hole and the third through hole.

In some embodiments, forming the gate pattern, the active layer pattern, the gate insulating layer, the first conductive pattern, the second conductive pattern, and the first intermediate insulating layer on the base substrate may include forming the gate pattern, the gate insulating layer, the active layer pattern, the first conductive pattern, the first intermediate insulating layer, and the second conductive pattern sequentially on the base substrate.

Claim 1 of the invention is an array substrate. The array substrate includes the thin film transistor according to one embodiment of the present disclosure. The array substrate further includes a base substrate and a pixel electrode pattern. The thin film transistor and the pixel electrode pattern are sequentially disposed on the base substrate. The pixel electrode pattern is electrically connected to the first conductive pattern.

The array substrate further includes a planarization layer on the thin film transistor. A sixth through hole is provided on the planarization layer, and the pixel electrode pattern is electrically connected to one of the first conductive pattern and the second conductive pattern through the sixth through hole.

The array substrate may further include a light shielding layer pattern and a buffer layer. The light shielding layer pattern, the buffer layer, and the thin film transistor may be sequentially stacked. The thin film transistor may include the second intermediate insulating layer, the active layer pattern, the gate insulating layer, the gate pattern, the second intermediate insulating layer, the first conductive pattern, the first intermediate insulating layer and the second conductive pattern in this sequence.

The source pattern includes a source, and the drain pattern may include a drain, a gap between an orthographic projection of the source on the base substrate and an orthogonal projection of the drain on the base substrate is 0, and the orthographic projection of the source on the substrate and the orthogonal projection of the drain on the substrate do not overlap.

The array substrate may further include a passivation layer and a common electrode pattern on the pixel electrode pattern.

Claim 4 of the invention is a method of fabricating an array substrate. The method of fabricating an array substrate includes forming a thin film transistor on a base substrate and forming a pixel electrode pattern on the thin film transistor. The thin film transistor includes a gate pattern, an active layer pattern, a gate insulating layer between the gate pattern and the active layer pattern, a first conductive pattern comprising a first pattern part and a first connecting part, a second conductive pattern comprising a second pattern part and a second connecting part, and a first intermediate insulating layer between the first pattern part and the second pattern part. The first conductive pattern and the second conductive pattern are a source pattern and a drain pattern, respectively, a first through hole is provided on the first intermediate insulating layer, and the second conductive pattern may be connected to the active layer pattern through the second connecting part in the first through hole. The pixel electrode pattern is electrically connected to the first conductive pattern.

The thin film transistor may further include a second intermediate insulating layer, and the active layer pattern, the gate insulating layer, the gate pattern, the second intermediate insulating layer, the first conductive pattern, the first intermediate insulating layer and the second conductive pattern may be stacked in this order.

Before forming the thin film transistor on the base substrate, the method may further include forming a light shielding layer pattern and a buffer layer sequentially on the base substrate. Forming the pixel electrode pattern on the thin film transistor may include forming a planarization layer on the thin film transistor and forming a pixel electrode pattern on the planarization layer. A sixth through hole may be provided on the planarization layer, and the pixel electrode pattern may be electrically connected to one of the first conductive pattern and the second conductive pattern through the sixth through hole.

Claim 7 is a display apparatus. The display apparatus includes an array substrate according to one embodiment of the present disclosure.

### BRIEF DESCRIPTION OF THE DRAWINGS

The subject matter which is regarded as the invention is particularly pointed out and distinctly claimed in the claims at the conclusion of the specification. The foregoing and other objects, features, and advantages of the invention are apparent from the following detailed description taken in conjunction with the accompanying drawings in which:
Fig. 1 is a schematic structural diagram of an array substrate in the related art;
Fig. 2-1 is a top view of a TFT according to an example which is not part of the claimed invention;
Fig. 2-2 is a cross-sectional view of Fig. 2-1 at line B-B';
Fig. 3-1 is a top view of a TFT according to an example which is not part of the claimed invention;
Fig. 3-2 is a cross-sectional view of Fig. 3-1 at line C-C';
Fig. 4-1 is a top view of a TFT according to an example which is not part of the claimed invention;
Fig. 4-2 is a cross-sectional view of Fig. 4-1 at line B-B';
Fig. 5 is a flow chart of a method for fabricating a TFT according to an embodiment of the present disclosure;
Fig. 6 is a flow chart of another method for fabricating a TFT according to an embodiment of the present disclosure;
Fig. 7-1 is a top view of an array substrate according to an example which is not part of the claimed invention;
Fig. 7-2 is a cross-sectional view of Fig. 7-1 at line D-D';
Fig. 8-1 is a top view of an array substrate according to an example which is not part of the claimed invention;
Fig. 8-2 is a cross-sectional view of Fig. 8-1 at line D-D';
Fig. 8-3 is a cross-sectional view of Fig 8-1 at line E-E';
Fig. 9-1 is a top view of an array substrate provided in the related art;
Fig. 9-2 is a cross-sectional view of Fig. 9-1 at line F-F';
Fig. 9-3 is a top view of an array substrate in the related art;
Fig. 9-4 is a cross-sectional view of Fig. 9-3 at line F-F';
Fig. 9-5 is a cross-sectional view of an array substrate in which the through hole does not penetrate through in the related art;
Fig. 10 is a schematic structural diagram of an array substrate according to the claimed invention;
Fig. 11 is a flowchart of a method for fabricating an array substrate according to an embodiment of the present disclosure; and
Fig. 12 is a flowchart of a method for fabricating an array substrate according to an embodiment of the present disclosure.

### DETAILED DESCRIPTION

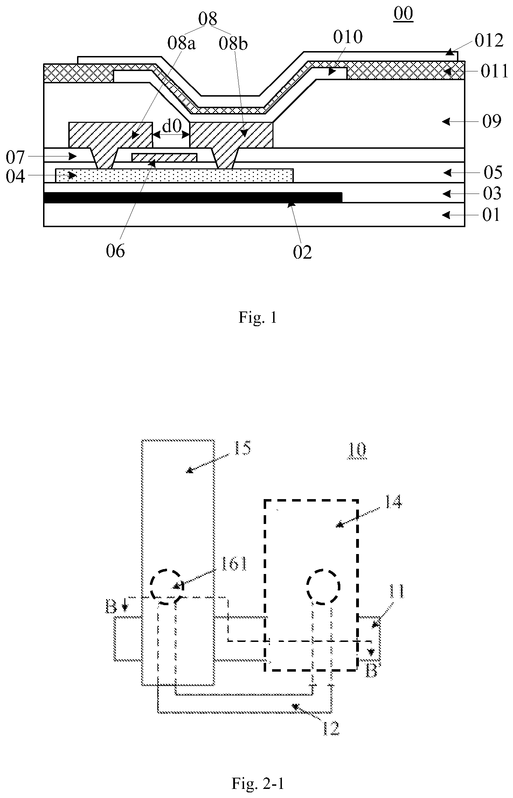

The present disclosure will be described in further detail with reference to the accompanying drawings and embodiments in order to provide a better understanding by those skilled in the art of the technical solutions of the present disclosure. Throughout the description of the disclosure, reference is made to Figs. 1-12. When referring to the figures, like structures and elements shown throughout are indicated with like reference numerals. The described embodiments are part of the embodiments of the present disclosure, and are not all embodiments. According to the embodiments of the present disclosure, all other embodiments obtained by persons of ordinary skill in the art without creative efforts, belong to the protection scope of the disclosure.

In the description of the present disclosure, the terms "first," "second," etc. may be used for illustration purposes only and are not to be construed as indicating or implying relative importance or implied reference to the quantity of indicated technical features. Thus, features defined by the terms "first" and "second" may explicitly or implicitly include one or more of the features. In the description of the present disclosure, the meaning of "plural" is two or more unless otherwise specifically and specifically defined.

In the description of the specification, references made to the terms "one embodiment," "some embodiments," "exemplary embodiments," "example," "specific example," "some examples" and the like are intended to refer that specific features and structures, materials or characteristics described in connection with the embodiment or example that are included in at least one embodiment or example of the present disclosure. The schematic expression of the terms does not necessarily refer to the same embodiment or example. Moreover, the specific features, structures, materials or characteristics described may be included in any suitable manner in any one or more embodiments or examples.

Fig. 1 is a schematic structural diagram of an array substrate provided by the related art. As shown in Fig. 1, the array substrate 00 includes a glass substrate 01, and a light shielding layer pattern 02, a buffer layer 03, an active layer pattern 04, a gate insulating layer 05, a gate pattern 06, an intermediate insulating layer 07, a source/drain pattern 08, a planarization layer 09, a pixel electrode pattern 010, a passivation layer 011, and a common electrode pattern 012 sequentially disposed on the glass substrate 01. When it is desired to increase the PPI of the array substrate 00, the distance d0 between the source 08a and the drain 08b in the source/drain pattern 08 can be reduced.

Generally, the source 08a and the drain 08b are formed by performing a patterning process on a source and drain film on the intermediate insulating layer 07. The patterning process may include photoresist coating, exposure, development, etching, and photoresist stripping. In the existing manufacturing process, since the source 08a and the drain 08b are made of a metal material, metal residues may exist between the source 08a and the drain 08b formed by the patterning process performed on the source and drain film. As a result, if the distance d0 between the source 08a and the drain 08b is too small, the source 08a and the drain 08b are easily short-circuited, thereby resulting in short-circuiting of the corresponding TFT and forming defective products.

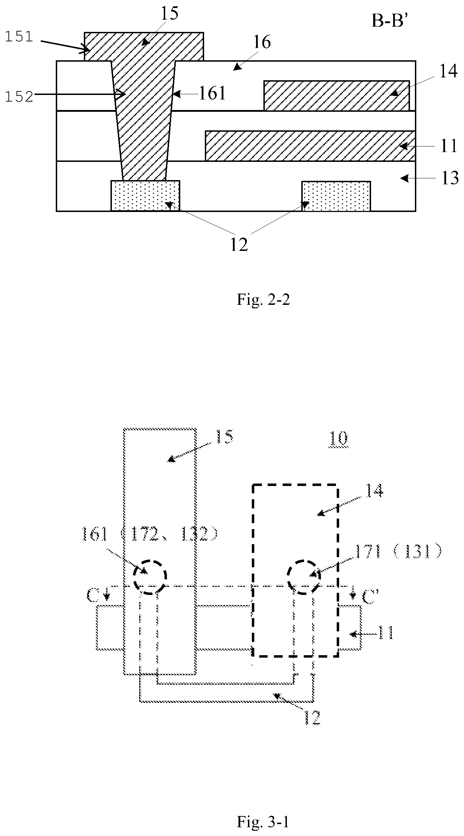

One example of the present disclosure which is not part of the claimed invention provides a TFT, which can improve the product yield of the TFT. Fig. 2-1 is a top view of a TFT provided by an example which is not part of the claimed invention. Fig. 2-2 is a sectional view of Fig. 2-1 along line B-B'. As shown in Fig. 2-1 and Fig. 2-2, the TFT 10 includes a gate pattern 11, an active layer pattern 12, and a gate insulating layer 13 between the gate pattern 11 and the active layer pattern 12. The TFT 10 may further include a first conductive pattern 14 and a second conductive pattern 15. The first conductive pattern 14 includes a first pattern part 141 and a first connecting part 142.The second conductive pattern 15 includes a second pattern part 151 and a second connecting part 152. The TFT 10 may further include a first intermediate insulating layer 16 between the first pattern part 141 and the second pattern part 151. In one embodiment, the first conductive pattern 14 and the second conductive pattern 15 are a source pattern and a drain pattern, respectively. That is, the first conductive pattern 14 is a source pattern, and the second conductive pattern 15 is a drain pattern. In another embodiment, the first conductive pattern 14 is a drain pattern, and the second conductive pattern 15 is a source pattern. The first intermediate insulating layer 16 is provided with a first through hole 161. The second conductive pattern 15 is connected to the active layer pattern 12 through the second connecting part 152 in the first through hole 161.

In the TFT provided in the embodiment of the present disclosure, a first intermediate insulating layer is disposed between the first pattern part and the second pattern part. The first conductive pattern and the second conductive pattern are a source pattern and a drain pattern, respectively. Therefore, the source pattern and the drain pattern are formed through two patterning processes. This can help in avoiding the problem of short circuiting between the source and the drain due to the short distance between the source and the drain when the existing source and drain are formed by one patterning process. As a result, the TFT product yield can be significantly improved.

The TFT may be a top-gate TFT or a bottom-gate TFT. The following embodiments of the present disclosure are illustrated by using the two implementable modes as examples respectively.

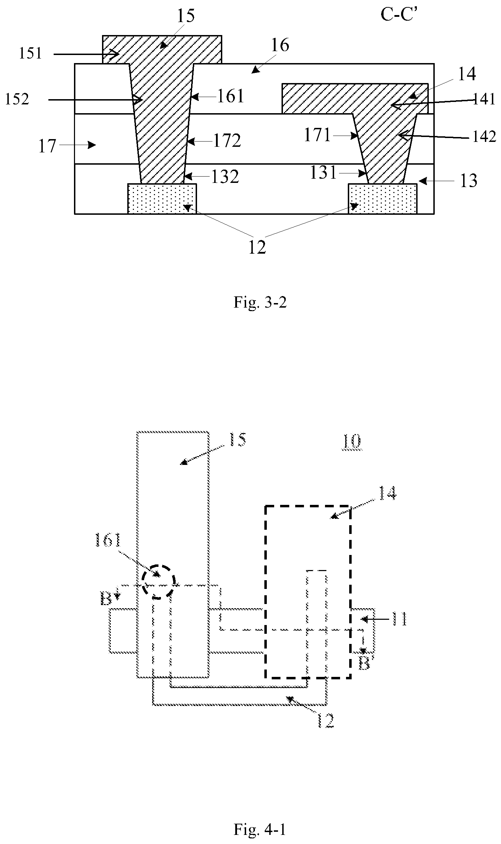

In the first an example which is not part of the claimed invention, the TFT is a top-gate TFT, as shown in Fig. 3-1 and Fig. 3-2. Fig. 3-1 is a top view of a TFT according to an example which is not part of the claimed invention. Fig. 3-2 is a cross-sectional view of Fig. 3-1 along line C-C'. The TFT 10 may further include a second intermediate insulating layer 17. The active layer pattern 12, the gate insulating layer 13, the gate pattern 11, the second intermediate insulating layer 17, the first conductive pattern 14, the first intermediate insulating layer 16, and the second conductive pattern 15 in the TFT 10 are sequentially stacked. The second intermediate insulating layer 17 is provided with a second through hole 171 and a third through hole 172. The first conductive pattern 14 is connected to the active layer pattern 12 through the first connecting part 142 in the second through hole 171. The second conductive pattern 15 is connected to the active layer pattern 12 through the second connecting part 152 in the first through hole 161 and the third through hole 172 in sequence.

In one example which is not part of the claimed invention, when the gate insulating layer 13 has a full-layer structure, as shown in Figs. 3-1 and 3-2, a fourth through hole 131 and a fifth through hole 132 may be disposed on the gate insulating layer 13. Then, the first conductive pattern 14 is connected to the active layer pattern 12 sequentially through the second through hole 171 and the fourth through hole 131. The second conductive pattern 15 is connected to the active layer pattern 12 sequentially through the first through hole 161, the third through hole 172, and the fifth through hole 132. In one example which is not part of the claimed invention, as shown in Fig. 3-1, the orthogonal projections of the first through hole 161, the third through hole 172, and the fifth through hole 132 in the vertical direction overlap. The orthogonal projections of the second through hole 171 and the fourth through hole 131 in the vertical direction overlap. The vertical direction is the stacking direction of the TFT layer structures, for example, the direction perpendicular to the paper surface in Fig. 3-1.

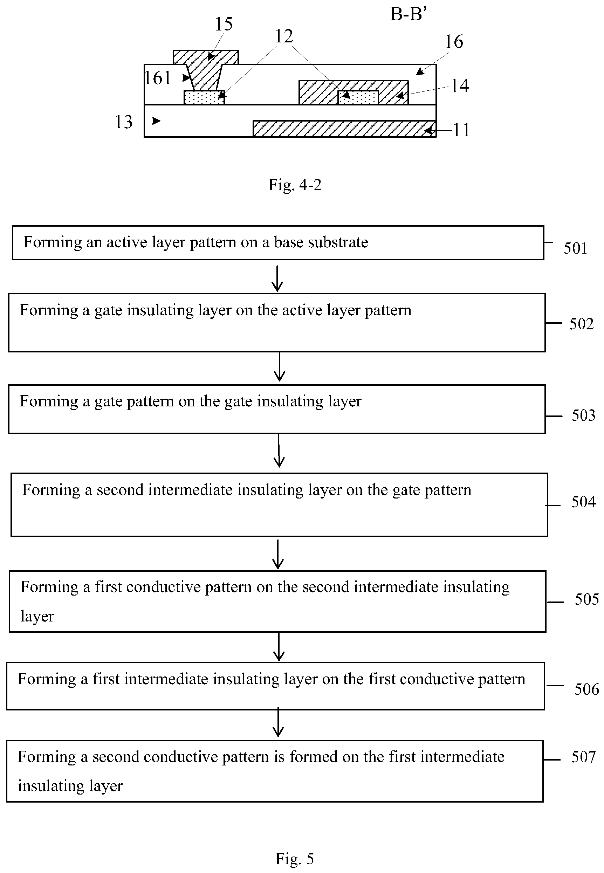

In the second example which is not part of the claimed invention, the TFT is a bottom-gate TFT, as shown in Fig. 4-1 and Fig. 4-2. Fig. 4-1 is a top view of yet another TFT provided by an embodiment of the present disclosure, and Fig. 4-2 is a cross-sectional view of Fig. 4-1 along line B-B'. The gate pattern 11, the gate insulating layer 13, the active layer pattern 12, the first conductive pattern 14, the first intermediate insulating layer 16, and the second conductive pattern 15 in the TFT 10 are sequentially stacked.

In the TFT provided in the embodiment of the present disclosure, a first intermediate insulating layer is disposed between the first pattern part and the second pattern part. The first conductive pattern and the second conductive pattern are a source pattern and a drain pattern, respectively. Therefore, the source pattern and the drain pattern are formed through two patterning processes. This can help in avoiding the problem of short circuiting between the source and the drain due to the short distance between the source and the drain when the existing source and drain are formed by one patterning process. As a result, the TFT product yield can be significantly improved.

Another example of the present disclosure provides a method for fabricating a TFT. The method includes the following:

A gate pattern, an active layer pattern, a gate insulating layer, a first conductive pattern, a second conductive pattern, and a first intermediate insulating layer are formed on the base substrate.

In one embodiment, the gate insulating layer is between the gate pattern and the active layer pattern, and the first intermediate insulating layer is located between the first pattern part and the second pattern part. The first conductive pattern and the second conductive pattern are a source pattern and a drain pattern, respectively. The first intermediate insulating layer is provided with a first through hole, and the second conductive pattern is connected to the active layer pattern through the first through hole.

In the method for fabricating a TFT provided in the embodiment of the present disclosure, a first intermediate insulating layer is disposed between the first pattern part and the second pattern part. The first conductive pattern and the second conductive pattern are a source pattern and a drain pattern, respectively. Therefore, the source pattern and the drain pattern are formed through two patterning processes. This can help in avoiding the problem of short circuiting between the source and the drain due to the short distance between the source and the drain when the existing source and drain are formed by one patterning process. As a result, the TFT product yield can be significantly improved.

The TFT may be a top-gate TFT or a bottom-gate TFT. The following methods for fabricating the TFT provided by the embodiments of the present disclosure are described schematically by using the two implementable modes as examples, respectively.

In the first embodiment, the TFT is a top gate type TFT. The fabricating method of the TFT may include the following: an active layer pattern, a gate insulating layer, a gate pattern, a second intermediate insulating layer, a first conductive pattern, a first intermediate insulating layer, and a second conductive pattern are sequentially formed on a base substrate. In order that the first conductive pattern may be connected to the active layer pattern and the second conductive pattern may be connected to the active layer pattern, the first intermediate insulating layer is provided with a first through hole, and the second intermediate insulating layer is provided with a second through hole and a third through hole. When the gate insulating layer is a full-layer structure, a fourth through hole and a fifth through hole may be disposed on the gate insulating layer. The first conductive pattern can be connected to the active layer pattern sequentially through the second through hole and the fourth through hole. The second conductive pattern can be connected to the active layer pattern sequentially through the first through hole, the third through hole, and the fifth through hole. In the TFT manufacturing process, using the second conductive pattern connecting with the active layer pattern as an example, the fifth through hole is first formed at the same time as the gate insulating layer is formed. Then, the third through hole is formed at the same time as the second intermediate insulating layer is formed. Finally, the first through hole is formed at the same time as the first intermediate insulating layer is formed. That is, the insulating layers in the TFT and the corresponding through holes are formed at the same time.

In another embodiment, the gate insulating layer, the second intermediate insulating layer, and the first intermediate insulating layer are formed in sequence, and then, the first through hole, the third through hole, and the fifth through hole are sequentially formed. That is, all insulating layers in the TFT are formed first, and then corresponding through holes are formed on each insulating layer respectively. The following embodiments are schematically illustrated by first forming all insulating layers in a TFT and then forming corresponding through holes on the insulating layers respectively.

Fig. 5 is a flowchart of a method for fabricating a TFT according to an embodiment of the present disclosure. The structure of the TFT fabricated by the method may refer to Fig. 3-2. The method may include the following:

In step 501, an active layer pattern is formed on a base substrate. The active layer pattern may be made of amorphous silicon, polysilicon, or the like. In one embodiment, an active layer film may be formed on the base substrate by any one of various methods such as deposition, coating, sputtering, etc., and then a patterning process is performed on the active layer film to form the active layer pattern. The patterning process may include photoresist coating, exposure, development, etching, and photoresist stripping.

In step 502, a gate insulating layer is formed on the active layer pattern. The gate insulating layer may be made of silicon dioxide, silicon nitride, or a mixture of silicon dioxide and silicon nitride. The gate insulating layer can be formed on the base substrate having the active layer pattern formed thereon by any of a variety of methods such as deposition, coating, sputtering, and the like.

In step 503, a gate pattern is formed on the gate insulating layer. The gate pattern can be formed using a metal material. For example, the gate pattern can be made of metal molybdenum (Mo), metal copper (Cu), metal aluminum (Al) or an alloy material. First, a gate film may be formed on the base substrate having the gate insulating layer formed thereon by any one of various methods such as deposition, coating, sputtering, etc., and then a patterning process is performed on the gate film to form the gate pattern. The patterning process may include photoresist coating, exposure, development, etching, and photoresist stripping.

In step 504, a second intermediate insulating layer is formed on the gate pattern. The second intermediate insulating layer may be made of silicon dioxide, silicon nitride, or a mixture of silicon dioxide and silicon nitride. The second intermediate insulating layer may be formed on the base substrate having the gate pattern formed thereon by any one of deposition, coating, sputtering, and other methods.

In step 505, a first conductive pattern is formed on the second intermediate insulating layer. The first conductive pattern can be a source pattern. The first conductive pattern can be formed using a metal material. For example, the gate pattern can be made of metal Mo, metal Cu, metal Al or an alloy material. The first conductive film may be formed on the base substrate having the second intermediate insulating layer formed thereon by any one of a plurality of methods such as deposition, coating, sputtering, and the like, and then a patterning process is performed on the first conductive film to form the first conductive pattern. The patterning process may include photoresist coating, exposure, development, etching, and photoresist stripping.

In the embodiment of the present disclosure, in order to connect the first conductive pattern with the active layer pattern, before step 505, a patterning process may be performed on the second intermediate insulating layer, so that a second through hole may be formed on the second intermediate insulating layer. The first conductive pattern is connected to the active layer pattern through the second through hole. If the gate insulating layer is a full-layer structure, for example, when it is desired to form the TFT shown in FIG. 3-2, a patterning process may be performed on the second intermediate insulating layer before step 505, and the etching time is increased in the patterning process. As such, a fourth through hole may be formed on the gate insulating layer after the second through hole is formed on the second intermediate insulating layer. At this time, the first conductive pattern is connected to the active layer pattern through the second through hole and the fourth through hole in sequence.

In step 506, a first intermediate insulating layer is formed on the first conductive pattern. The first intermediate insulating layer may be made of silicon dioxide, silicon nitride or a mixture of silicon dioxide and silicon nitride._The first intermediate insulating layer may be formed on the base substrate having the first conductive pattern formed thereon by any one of a plurality of methods of deposition, coating, sputtering, and the like.

In step 507, a second conductive pattern is formed on the first intermediate insulating layer. The second conductive pattern may be a drain pattern. The second conductive pattern may be formed using a metal material. For example, the gate pattern may be made of metal Mo, metal Cu, metal Al, or an alloy material.

A second conductive film may be first formed on the base substrate having the first intermediate insulating layer formed thereon by any one of a plurality of methods such as deposition, coating, sputtering, and the like, and then a patterning process is performed on the second conductive film to form the second conductive pattern. The patterning process may include photoresist coating, exposure, development, etching, and photoresist stripping.

In the embodiment of the present disclosure, in order to connect the second conductive pattern with the active layer pattern, before the step 507, a patterning process may be performed on the first intermediate insulating layer, and then a first through hole is formed on the first intermediate insulating layer. Then, a third through hole is formed on the second intermediate insulating layer, so that the second conductive pattern can be connected to the active layer patterns sequentially through the first through hole and the third through hole.

If the gate insulating layer is a full-layer structure, for example, when it is desired to form the TFT shown in Fig. 3-2, a patterning process may be performed on the first intermediate insulating layer before step 507, and the etching time in the patterning process may be increased. Further, a first through hole may be formed on the first intermediate insulating layer, a third through hole may be formed on the second intermediate insulating layers, and a fifth through hole may be formed on the gate insulating layer. At this time, the second conductive pattern can be connected to the active layer pattern sequentially through the first through hole, the third through hole, and the fifth through hole.

In the second embodiment, the TFT is a bottom gate type TFT. The method of fabricating the TFT may include sequentially forming a gate pattern, a gate insulating layer, an active layer pattern, a first conductive pattern, a first intermediate insulating layer, and a second conductive pattern on a base substrate.

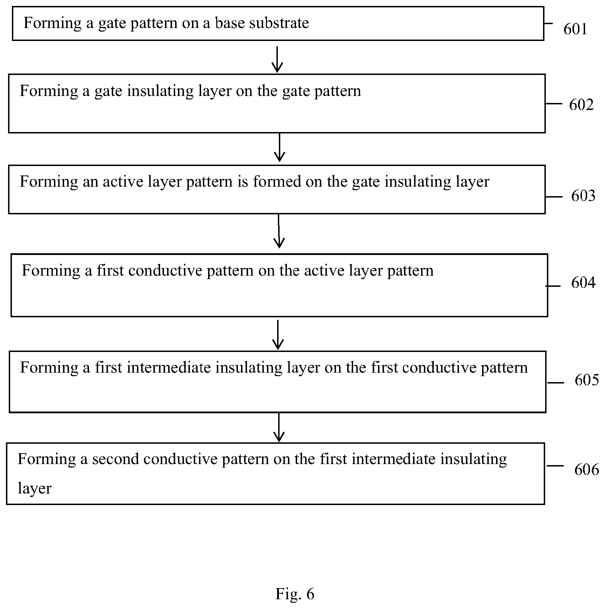

Fig. 6 is a flow chart of another method of fabricating a TFT according to an embodiment of the present disclosure. The structure of the TFT fabricated by the method may refer to Fig. 4-2. The method may include the following:

In step 601, a gate pattern is formed on a base substrate. For the step 601, reference may be made to the corresponding process in the foregoing step 503, and the detail thereof is not repeated herein.

In step 602, a gate insulating layer is formed on the gate pattern. For the step 602, reference may be made to the corresponding process in the foregoing step 502, and the detail thereof is not repeated herein.

In step 603, an active layer pattern is formed on the gate insulating layer. For the step 603, reference may be made to the corresponding process in the foregoing step 501, and the detail thereof is not repeated herein.

In step 604, a first conductive pattern is formed on the active layer pattern. For the step 604, reference may be made to the corresponding process in the foregoing step 505, and the detail thereof is not repeated herein.

In step 605, a first intermediate insulating layer is formed on the first conductive pattern. For the step 605, reference may be made to the corresponding process in the foregoing step 506, and the detail thereof is not repeated herein.

In step 606, a second conductive pattern is formed on the first intermediate insulating layer. For the step 606, reference may be made to the corresponding process in the foregoing step 507, the detail thereof is not repeated herein.

In the embodiment of the present disclosure, in order to connect the second conductive pattern with the active layer pattern, a patterning process may be performed on the first intermediate insulating layer before step 606, so that the first through hole may be formed on the first intermediate insulating layer. The second conductive pattern may be connected to the active layer pattern through the first through hole.

For convenience and brevity of description, specific principles of the TFT described above may refer to corresponding contents in the foregoing embodiments of the TFT, and the details are not described herein again.

In the method for manufacturing a TFT provided in the embodiment of the present disclosure, a first intermediate insulating layer is disposed between the first pattern part and the second pattern part. The first conductive pattern and the second conductive pattern are a source pattern and a drain pattern, respectively. Therefore, the source pattern and the drain pattern are formed through two patterning processes. This can help in avoiding the problem of short circuiting between the source and the drain due to the short distance between the source and the drain when the existing source and drain are formed by one patterning process. As a result, the TFT product yield can be significantly improved.

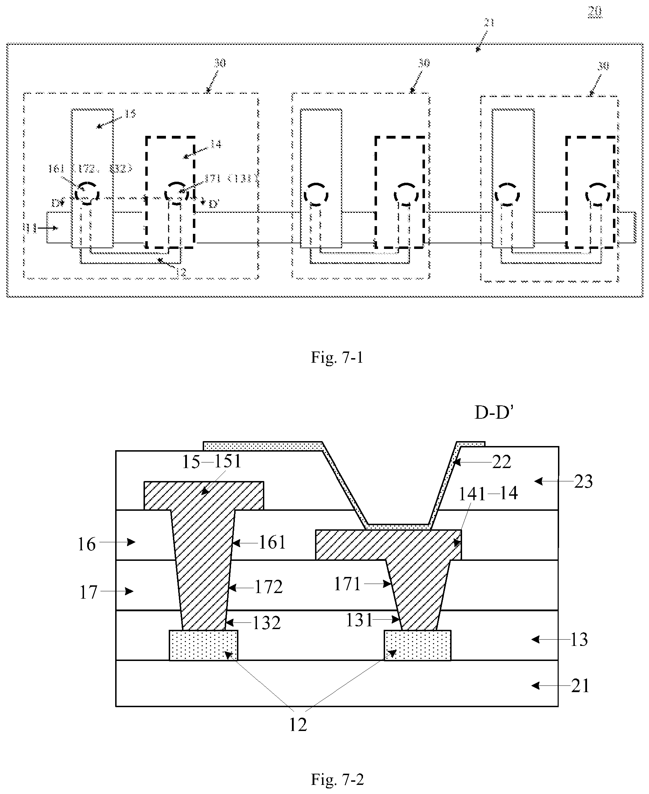

Another example which is not part of the claimed invention provides an array substrate, as shown in Fig. 7-1 and Fig. 7-2. Fig. 7-1 is a top view of an array substrate provided by an embodiment of the present disclosure, and Fig. 7-2 is a sectional view along line D-D' in Fig. 7-1._The array substrate 20 may include a base substrate 21. On the base substrate 21, a TFT and a pixel electrode pattern 22 are sequentially disposed. It should be noted that the embodiment of the present disclosure is schematically illustrated by taking the TFT in the array substrate 20 shown in Fig. 3-2 as an example. In practical applications, the TFT may also be the TFT shown in Fig. 2-2 or Fig. 4-2. The structure of the array substrate formed by the TFT shown in Fig. 2-2 or Fig. 4-2 is similar to the structure of the array substrate formed by the illustrated TFT as shown in Fig. 3-2 and accordingly it is not described in detail again.

In one example which is not part of the claimed invention, the pixel electrode 22 is electrically connected to one of the first conductive pattern 14 and the second conductive pattern 15. In the following examples which are not part of the claimed invention, an example in which the pixel electrode 22 is electrically connected to the first conductive pattern 14 is taken for illustration, and the description is similarly applicable for a case in which the pixel electrode 22 and the second conductive pattern 15 are electrically connected.

In one example which is not part of the claimed invention, the first conductive pattern 14 may include a source 141, and the second conductive pattern 15 may include a drain 151. The array substrate shown in Fig. 7-1 only shows the structures of the source, the drain, the gate, and the active layer in the TFT in the array substrate, and other structures (e.g., pixel electrodes) are not shown. Furthermore, Fig. 7-1 shows three pixels 30 with one TFT in each pixel 30.

In the related art, in order to avoid the short circuiting between the source and the drain in the TFT, when designing the TFT, it is necessary to consider the limit of the distance between the source and the drain. However, in the embodiment of the present disclosure, a first intermediate insulating layer is disposed between the first pattern part and the second pattern part. Therefore, the first conductive pattern and the second conductive pattern are formed through two patterning processes. It is possible to avoid short circuiting between the source and the drain without considering the limit of the distance between the source and the drain. Therefore, the distance between the source and the drain can be designed smaller so that an array substrate with a higher PPI can be designed.

According to the array substrate provided by the embodiment of the present disclosure, since the first intermediate insulating layer is disposed between the first pattern part and the second pattern part, and the first conductive pattern and the second conductive pattern are the source pattern and the drain pattern, respectively, the source pattern and the drain pattern are formed by two patterning processes. This can help in avoiding the problem of short circuiting between the source and the drain due to the short distance between the source and the drain when the existing source and drain are formed by one patterning process. As a result, the TFT product yield can be significantly improved. Furthermore, on the premise of avoiding short-circuiting between the source and the drain, the distance between the source and the drain can be effectively reduced, and accordingly the PPI of the array substrate can be further improved.

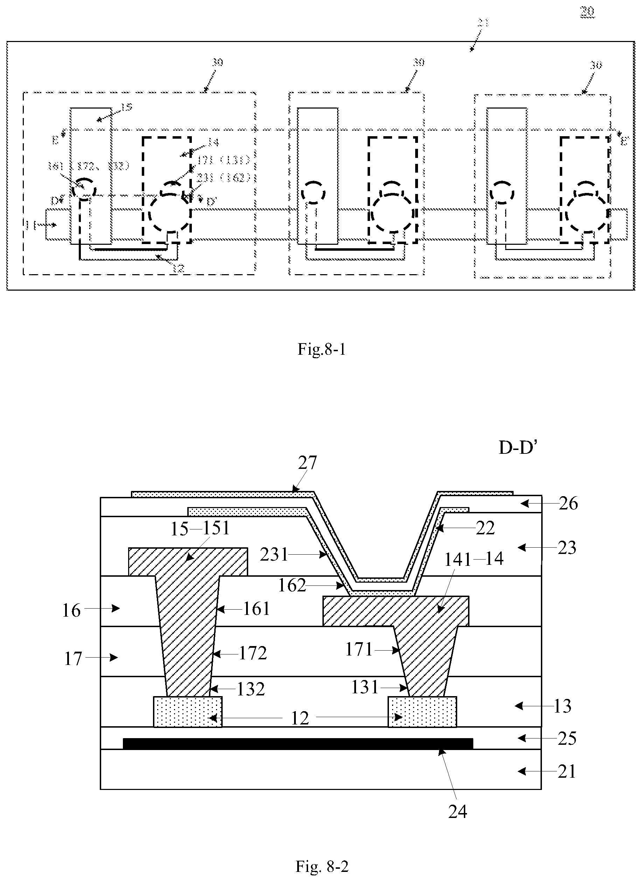

Fig. 8-1 is a top view of another array substrate provided by an example which is not part of the claimed invention, and Fig. 8-2 is a cross-sectional view along line D-D' in Fig. 8-1. The array substrate 20 may also include a planarization layer 23 provided on the TFT. The planarization layer 23 is provided with a sixth through hole 231. The pixel electrode pattern 22 can be electrically connected to the first conductive pattern 14 through the sixth through hole 231. In practical applications, a seventh through hole 162 may be further provided on the first intermediate insulating layer 16 in the TFT, and the pixel electrode pattern 22 may be electrically connected to the first conductive pattern 14 sequentially through the sixth through hole 231 and the seventh through hole 162. The array substrate shown in Fig. 8-1 shows only the structures of the source, the drain, the gate, and the active layer in the TFT in the array substrate, and other structures (e.g., the pixel electrode and the planarization layer etc.) are not shown.

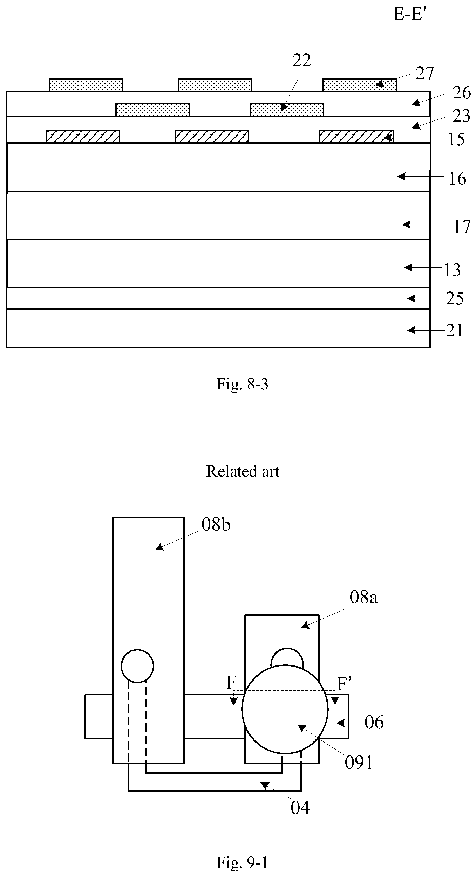

In one example which is not part of the claimed invention, Fig. 8-3 is a cross-sectional view along line E-E' in Fig. 8-1. For the top-gate type TFT, when light enters the array substrate 20 through the base substrate 21, the gate pattern 11 cannot cover the active layer pattern 12 to block the light. In order to avoid serious drift of the threshold voltage of the TFT, a light shielding structure needs to be provided. Therefore, the array substrate 20 may further include a light shielding layer pattern 24 and a buffer layer 25, and the light shielding layer pattern 24, the buffer layer 25, and the TFT are sequentially stacked.

In one example which is not part of the claimed invention, as shown in Figs. 8-2 and 8-3, the array substrate may further include a passivation layer 26 and a common electrode pattern 27 staggered on the pixel electrode pattern 22.

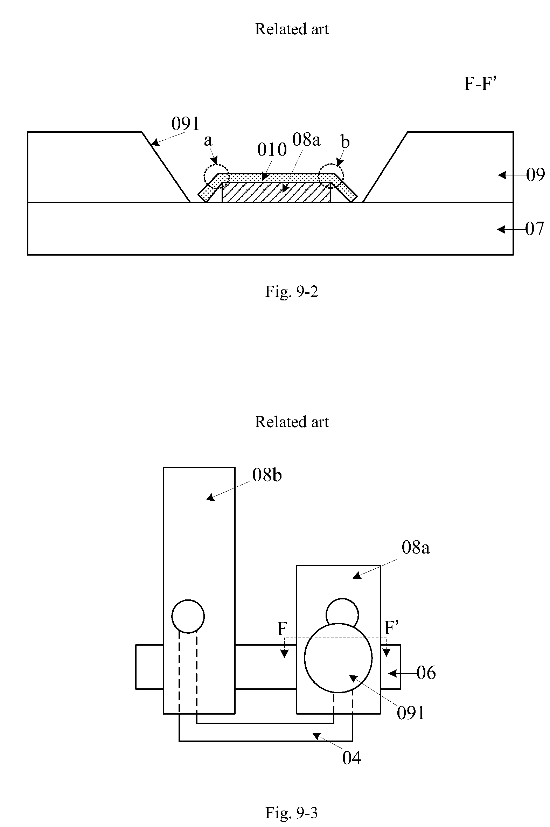

In the related art, the drain is connected with the data line in the array substrate, and the source is connected with the pixel electrode in the array substrate. In order to increase the PPI of the array substrate, the width of the source needs to be reduced. For example, as shown in Fig. 9-1 and 9-2, Fig. 9-1 is a top view of an array substrate provided in the related art, and Fig 9-2 is a cross-sectional view along line F-F' in Fig. 9-1. The array substrate shown in Fig. 9-1 shows only the structures of the source 08a, the drain 08b, the gate 06, and the active layer pattern 04 in the array substrate, and other structures (e.g., pixel electrodes) are not shown. Fig. 9-2 shows only the structures of the intermediate insulating layer 07, the planarization layer 09, the source 08a, and the partial pixel electrode pattern 010, and other structures are not shown. A through hole 091 is provided on the planarization layer 09. If the width of the source 08a is reduced and in order to ensure that the source 08a and the pixel electrode pattern 010 can be fully connected, the width of the through hole 091 can be increased. However, at this time, the pixel electrode pattern 010 has a step difference at a or b so that a crack can easily occur, resulting in a weak connection between the source electrode 08a and the pixel electrode pattern 010. As a result, dark spots may appear after the display apparatus is subsequently formed.

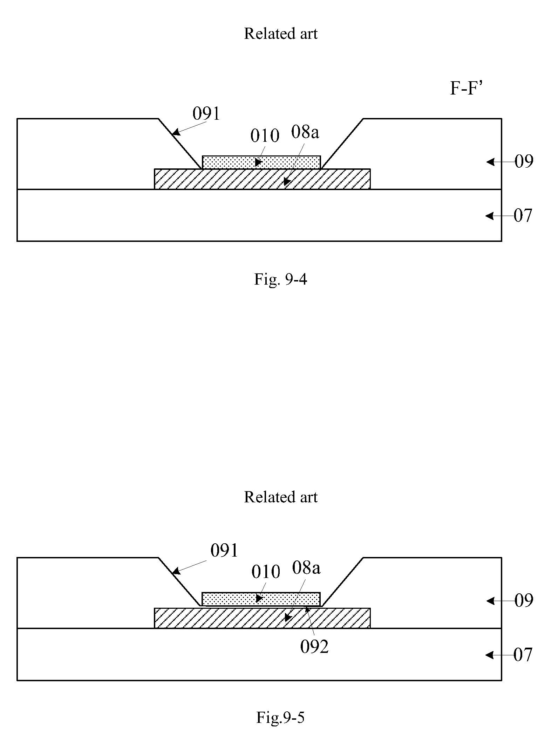

Fig. 9-3 is a top view of another array substrate provided by the related art, and Fig. 9-4 is a cross-sectional view along F-F' in Fig. 9-3. As shown in Fig. 9-3 and Fig. 9-4, in order to avoid the risk of breakage of the pixel electrode pattern 010, the width of the source 08a is increased while the width of the through hole 091 is reduced. As such, not only does this avoid the risk of breakage of the pixel electrode pattern 010, but also it can ensure that the PPI of the array substrate shown in Fig. 9-3 is the same as the PPI of the array substrate shown in Fig. 9-2._However, because the width of the through hole 091 is too small, when the through hole 091 is formed, it is possible that the through hole is not through. For example, Fig. 9-5 is a diagram illustrating the effect that the through hole 091 was not through in the related art. Accordingly, there is a residual portion 092 at the bottom of this through hole 091, which causes a weak connection between the source 08a and the pixel electrode pattern 010, and finally dark spots may still appear after the display apparatus is subsequently formed.

In the example which is not part of the claimed invention, as shown in Figs. 8-1 and 8-2, there is no need to consider the limit of the distance between the source 141 and the drain 151. Because the PPI of the array substrate 20 remains relatively high, the width of the source 141 can be increased, and the width of the sixth through hole 231 in the planarization layer 23 can be increased. As such, it is ensured that sufficient connection between the pixel electrode 22 and the source electrode 141 is formed while the phenomenon that the sixth through hole does not penetrate through is avoided, thereby effectively avoiding the occurrence of dark spots in the subsequently formed display apparatus.

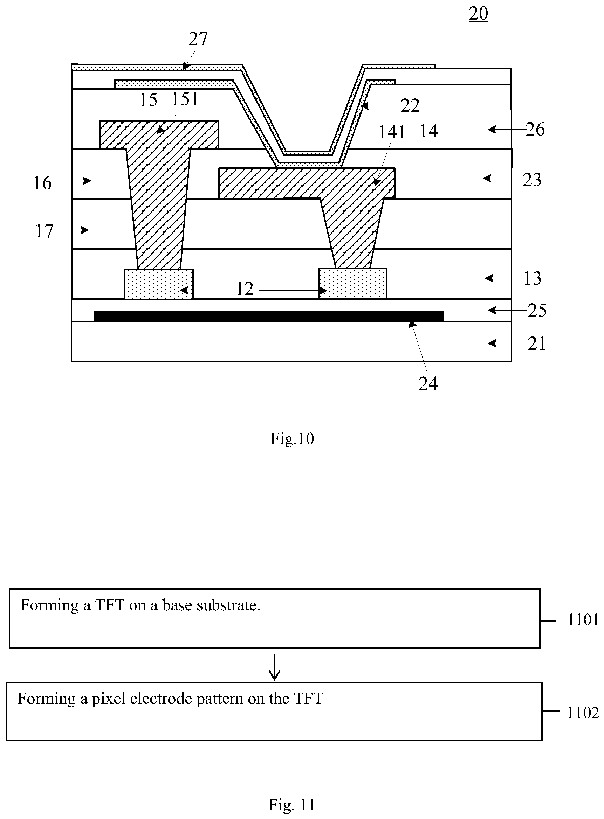

Fig. 10 is a schematic structural diagram of yet another array substrate according to the claimed invention. The gap between the orthogonal projection of the source 141 of the array substrate 20 on the substrate 21 and the orthogonal projection of the drain 151 on the substrate is 0. In addition, there is no overlapping area between the orthogonal projection of the source 141 on the base substrate 21 and the orthographic projection of the drain 151 on the base substrate 21. That is, the distance between the source 141 and the drain 151 is 0. At this time, the distance between the source 141 and the drain 151 in the array substrate 20 is the minimal so that the PPI of the array substrate 20 is maximal.

According to the array substrate provided by the claimed invention, since the first intermediate insulating layer is disposed between the first conductive pattern and the second conductive pattern, and the first conductive pattern and the second conductive pattern are the source pattern and the drain pattern, respectively, the source pattern and the drain pattern are formed by two patterning processes. This can help in avoiding the problem of short circuiting between the source and the drain due to the short distance between the source and the drain when the existing source and drain are formed by one patterning process. As a result, the TFT product yield can be significantly improved. Furthermore, by avoiding short-circuiting between the source and the drain, the distance between the source and the drain can be effectively reduced so that the PPI of the array substrate can be increased, and accordingly the occurrence of dark spots in the subsequently formed display apparatus can be effectively avoided.

Another example of the present disclosure provides a method for fabricating an array substrate, as shown in Fig. 11. Fig. 11 is a flowchart of a method for fabricating an array substrate according to an embodiment of the present disclosure. The method may include the following:

In step 1101, a TFT is formed on a base substrate.

In step 1102, a pixel electrode pattern is formed on the TFT.

In one embodiment, the TFT includes a gate pattern, an active layer pattern, and a gate insulating layer between the gate pattern and the active layer pattern. The TFT further includes a first conductive pattern, a second conductive pattern, and a first intermediate insulating layer between the first pattern part and the second pattern part. The first conductive pattern and the second conductive pattern are a source pattern and a drain pattern, respectively. The first intermediate insulating layer is provided with a first through hole, and the second conductive pattern is connected with the active layer pattern through the first through hole. The pixel electrode pattern is electrically connected to one of the first conductive pattern and the second conductive pattern.

According to the array substrate provided by the embodiment of the present disclosure, since the first intermediate insulating layer is disposed between the first pattern part and the second pattern part, and since the first conductive pattern and the second conductive pattern are the source pattern and the drain pattern, respectively, the source pattern and the drain pattern are formed by two patterning processes. This can help in avoiding the problem of short circuiting between the source and the drain due to the short distance between the source and the drain when the existing source and drain are formed by one patterning process. As a result, the TFT product yield can be significantly improved. Furthermore, on the premise of avoiding short-circuiting between the source and the drain, the distance between the source and the drain can be effectively reduced so that the PPI of the array substrate can be increased.

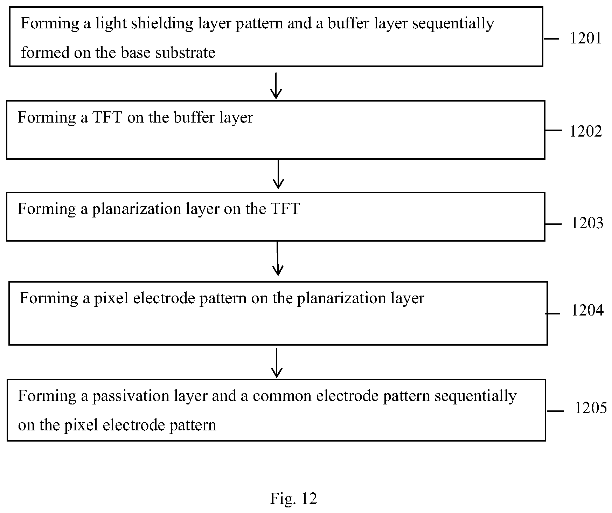

Fig. 12 is a flowchart of another method for fabricating an array substrate according to an embodiment of the present disclosure. The method may include the following.

In step 1201, a light shielding layer pattern and a buffer layer are sequentially formed on the base substrate. In one embodiment, a light shielding layer film may be formed on the base substrate by any one of various methods such as deposition, coating, sputtering, etc., and then a patterning process is performed on the light shielding layer film to form the light shielding layer pattern. The patterning process may include photoresist coating, exposure, development, etching, and photoresist stripping. Then, a buffer layer is formed on the base substrate having the light shielding layer pattern formed thereon by any one of various methods such as deposition, coating, sputtering, and the like.

In step 1202, a TFT is formed on the buffer layer. For the step 1202, reference may be made to the corresponding process in the foregoing step 501 to step 507, which is not repeated herein.

In step 1203, a planarization layer is formed on the TFT. The planarization layer may be formed by any one of a plurality of methods such as deposition, coating, sputtering, and the like on the base substrate having the TFT formed thereon.

In step 1204, a pixel electrode pattern is formed on the planarization layer. The pixel electrode pattern may be made of indium tin oxide (ITO). A pixel electrode film may be formed on the base substrate having the TFT formed thereon by any one of a plurality of methods such as deposition, coating, sputtering, and the like, and then a patterning process is performed on the pixel electrode film to form the pixel electrode pattern. The patterning process may include photoresist coating, exposure, development, etching, and photoresist stripping.

In the embodiment of the present disclosure, in order to electrically connect the pixel electrode pattern with one of the first conductive pattern and the second conductive pattern in the TFT, before step 1204, a patterning process may be performed on the planarization layer, and then a sixth through hole may be formed on the planarization layer so that the pixel electrode pattern may be electrically connected to the second conductive pattern in the TFT through the sixth through hole. Alternatively, before step 1204, a patterning process may be performed on the planarization layer, and the etching time in the patterning process may be increased, and then the sixth through hole is formed on the planarization layer, and a seventh through hole is formed on the first intermediate insulating layer in the TFT. As such, the pixel electrode pattern can be electrically connected to the first conductive pattern in the TFT sequentially through the sixth through hole and the seventh through hole.

In step 1205, a passivation layer and a common electrode pattern are sequentially formed on the pixel electrode pattern. The common electrode pattern may be made of ITO. The passivation layer may be formed on the base substrate having the TFT formed thereon by any of various methods such as deposition, coating, sputtering, and the like. A common electrode film is formed on the array substrate having the passivation layer formed thereon by any of a plurality of methods such as deposition, coating, sputtering, etc., and then a patterning process is performed on the common electrode film to form the common electrode pattern.

In one embodiment, the above steps 1201 to 1205 can form a top-gate array substrate. For example, the array substrate shown in Fig. 8-2 may be formed. In the embodiment of the present disclosure, a bottom-gate array substrate can also be formed. For example, a TFT may be formed on a base substrate. For the process, reference may be made to the corresponding process in the foregoing step 601 to step 606, which are not described herein. Then, the above step 1203 to step 1205 may be performed.

For convenience and brevity of description, specific principles of the above-described array substrate can refer to corresponding contents in the foregoing embodiments of the array substrate, and the details thereof are not described herein again.

According to the array substrate provided by the embodiment of the present disclosure, since the first intermediate insulating layer is disposed between the first conductive pattern and the second conductive pattern, and since the first conductive pattern and the second conductive pattern are the source pattern and the drain pattern respectively, the source pattern and the drain pattern are formed by two patterning processes. This can help in avoiding the problem of short circuiting between the source and the drain due to the short distance between the source and the drain when the existing source and drain are formed by one patterning process. As a result, the TFT product yield can be significantly improved. Furthermore, by avoiding short-circuiting between the source and the drain, the distance between the source and the drain can be effectively reduced so that the PPI of the array substrate can be increased, and accordingly the occurrence of dark spots in the subsequently formed display apparatus can be effectively avoided.

Another example of the present disclosure provides a display apparatus, which may include the array substrate according to one embodiment of the present disclosure. The display apparatus may be a liquid crystal panel, an organic light-emitting diode (OLED) display panel, an electronic paper, a mobile phone, a tablet computer, a television, a display, a notebook computer, a digital photo frame, a navigator, or any product or component that has a display function.

Those of ordinary skill in the art can understand that all or part of the steps for implementing the above embodiments can be completed by hardware, and can also be instructed by a program to perform the relevant hardware. The program can be stored in a computer-readable storage medium. The storage medium mentioned may be a read-only memory, a magnetic or optical disk, etc.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. An array substrate, comprising a thin film transistor (10), wherein the thin film transistor (10) comprises:
a gate pattern (11);
an active layer pattern (12);
a gate insulating layer (13) between the gate pattern (11) and the active layer pattern (12);
a first conductive pattern (14) comprising a first pattern part (141) and a first connecting part (142);
a second conductive pattern (15) comprising a second pattern part (151) and a second connecting part (152);
a first intermediate insulating layer (16) between the first pattern part (141) and the second pattern part (151), and the first intermediate insulating layer (16) arranged on the first pattern part (141) and the second pattern part (151) arranged on the first intermediate insulating layer (16); and
a planarization layer (23) on the thin film transistor (10), wherein a first through hole (231) is provided on the planarization layer (23);
wherein the first conductive pattern (14) and the second conductive pattern (15) are a source pattern and a drain pattern, respectively, a second through hole (161) is provided on the first intermediate insulating layer (16), and the second conductive pattern (15) is connected to the active layer pattern (12) through the second connecting part (152) in the second through hole (161);
the array substrate further comprises:
a base substrate (21); and
a pixel electrode pattern (22),
wherein the thin film transistor (10) and the pixel electrode pattern (22) are sequentially disposed on the base substrate (21), and
the pixel electrode pattern (22) is electrically connected to the first pattern part (141) through the first through hole (231); and
wherein the source pattern comprises a source, and the drain pattern comprises a drain, a gap between an orthographic projection of the source on the base substrate and an orthogonal projection of the drain on the base substrate is 0, **characterized in that**
the orthographic projection of the source on the substrate and the orthogonal projection of the drain on the substrate do not overlap.

2. The array substrate according to claim 1, further comprising a passivation layer (26) and a common electrode pattern (27) on the pixel electrode pattern (22).

3. The array substrate according to claim 1, further comprising:
a light shielding layer pattern (24) and a buffer layer (25);
wherein the light shielding layer pattern (24), the buffer layer (25), and the thin film transistor (10) are sequentially stacked; and
wherein the thin film transistor (10) comprises a second intermediate insulating layer (17), the active layer pattern (12), the gate insulating layer (13), the gate pattern (11), the second intermediate insulating layer (17), the first conductive pattern (14), the first intermediate insulating layer (16) and the second conductive pattern (15) in this sequence.

4. A method of fabricating an array substrate, comprising:
forming a thin film transistor (10) on a base substrate (21); and
forming a pixel electrode pattern (22) on the thin film transistor (10);
wherein the thin film transistor comprises a gate pattern (11), an active layer pattern (12), a gate insulating layer (13) between the gate pattern (11) and the active layer pattern (12), a first conductive pattern (14) comprising a first pattern part (141) and a first connecting part (142), a second conductive pattern (15) comprising a second pattern part (151)and a second connecting part (152), and a first intermediate insulating layer (16) between the first pattern part (141) and the second pattern part (151), and the first intermediate insulating layer (16) arranged on the first pattern part (141) and the second pattern part (151) arranged on the first immediate insulating layer (16);
wherein the first conductive pattern (14) and the second conductive pattern (15) are a source pattern and a drain pattern, respectively, a first through hole (161) is provided on the first intermediate insulating layer (16), and the second conductive pattern (15) is connected to the active layer pattern (12) through the second connecting part (152) in the first through hole (161); and
wherein the pixel electrode pattern (22) is electrically connected to the first pattern part (141); and
the forming the pixel electrode pattern (22) on the thin film transistor (10) comprises:
forming a planarization layer (23) on the thin film transistor (10); and
forming a pixel electrode pattern (22) on the planarization layer (23);
wherein a second through hole (231) is provided on the planarization layer (23), and the pixel electrode pattern (22) is electrically connected to the first pattern part (141) through the second through hole (231); and
wherein the source pattern comprises a source, and the drain pattern comprises a drain, a gap between an orthographic projection of the source on the base substrate and an orthogonal projection of the drain on the base substrate is 0, **characterized in that**
the orthographic projection of the source on the substrate and the orthogonal projection of the drain on the substrate do not overlap.

5. The method of fabricating an array substrate according to claim 4, wherein the thin film transistor (10) further comprises a second intermediate insulating layer (17), and the active layer pattern (12), the gate insulating layer (13), the gate pattern (11), the second intermediate insulating layer (17), the first conductive pattern (14), the first intermediate insulating layer (16) and the second conductive pattern (15) are stacked in this order.

6. The method of fabricating an array substrate according to claim 4, wherein before forming the thin film transistor on the base substrate (21), the method further comprises forming a light shielding layer pattern (24) and a buffer layer (25) sequentially on the base substrate (21).

7. A display apparatus, comprising an array substrate according to any one of claims 1 to 3.

## Patentansprüche

1. Arraysubstrat, einen Dünnschichttransistor (10) aufweisend, wobei der Dünnschichttransistor (10) aufweist:
ein Gate-Muster (11);
ein aktives Schichtmuster (12);
eine Gate-Isolierschicht (13) zwischen dem Gate-Muster (11) und dem aktiven Schichtmuster (12);
ein erstes leitfähiges Muster (14), das einen ersten Musterteil (141) und einen ersten Verbindungsteil (142) aufweist;
ein zweites leitfähiges Muster (15), das einen zweiten Musterteil (151) und einen zweiten Verbindungsteil (152) aufweist;
eine erste Zwischenisolierschicht (16) zwischen dem ersten Musterteil (141) und dem zweiten Musterteil (151), wobei die erste Zwischenisolierschicht (16) auf dem ersten Musterteil (141) angeordnet ist und der zweite Musterteil (151) auf der ersten Zwischenisolierschicht (16) angeordnet ist; und
eine Planarisierungsschicht (23) auf dem Dünnschichttransistor (10), wobei ein erstes Durchgangsloch (231) auf der Planarisierungsschicht (23) vorgesehen ist;
wobei das erste leitfähige Muster (14) und das zweite leitfähige Muster (15) jeweils ein Source-Muster und ein Drain-Muster sind, ein zweites Durchgangsloch (161) auf der ersten Zwischenisolierschicht (16) vorgesehen ist und das zweite leitfähige Muster (15) über den zweiten Verbindungsteil (152) in dem zweiten Durchgangsloch (161) mit dem aktiven Schichtmuster (12) verbunden ist;
das Arraysubstrat ferner aufweist:
ein Basissubstrat (21); und
ein Pixelelektrodenmuster (22),
wobei der Dünnschichttransistor (10) und das Pixelelektrodenmuster (22) aufeinanderfolgend auf dem Basissubstrat (21) angeordnet sind und
das Pixelelektrodenmuster (22) über das erste Durchgangsloch (231) mit dem ersten Musterteil (141) elektrisch verbunden ist; und
wobei das Source-Muster eine Source aufweist und das Drain-Muster einen Drain aufweist, wobei ein Abstand zwischen einer orthographischen Projektion der Source auf dem Basissubstrat und einer orthogonalen Projektion des Drains auf dem Basissubstrat 0 beträgt, **dadurch gekennzeichnet, dass** sich die orthographische Projektion der Source auf dem Substrat und die orthogonale Projektion des Drains auf dem Substrat nicht überlappen.

2. Arraysubstrat nach Anspruch 1, ferner eine Passivierungsschicht (26) und ein gemeinsames Elektrodenmuster (27) auf dem Pixelelektrodenmuster (22) aufweisend.

3. Arraysubstrat nach Anspruch 1, ferner aufweisend:
ein Lichtabschirmungsschichtmuster (24) und eine Pufferschicht (25);
wobei das Lichtabschirmungsschichtmuster (24), die Pufferschicht (25) und der Dünnschichttransistor (10) aufeinanderfolgend gestapelt sind; und
wobei der Dünnschichttransistor (10) eine zweite Zwischenisolierschicht (17), das aktive Schichtmuster (12), die Gate-Isolierschicht (13), das Gate-Muster (11), die zweite Zwischenisolierschicht (17), das erste leitfähige Muster (14), die erste Zwischenisolierschicht (16) und das zweite leitfähige Muster (15) in dieser Reihenfolge aufweist.

4. Verfahren zur Herstellung eines Arraysubstrats, umfassend:
Bilden eines Dünnschichttransistors (10) auf einem Basissubstrat (21); und
Bilden eines Pixelelektrodenmusters (22) auf dem Dünnschichttransistor (10);
wobei der Dünnschichttransistor ein Gate-Muster (11), ein aktives Schichtmuster (12), eine Gate-Isolierschicht (13) zwischen dem Gate-Muster (11) und dem aktiven Schichtmuster (12), ein erstes leitfähiges Muster (14), das ein erstes Musterteil (141) und einen ersten Verbindungsteil (142) aufweist, ein zweites leitfähiges Muster (15), das einen zweiten Musterteil (151) und einen zweiten Verbindungsteil (152) aufweist, und eine erste Zwischenisolierschicht (16) zwischen dem ersten Musterteil (141) und dem zweiten Musterteil (151) aufweist und die erste Zwischenisolierschicht (16) auf dem ersten Musterteil (141) und der zweite Musterteil (151) auf der ersten Zwischenisolierschicht (16) angeordnet sind;
wobei das erste leitfähige Muster (14) und das zweite leitfähige Muster (15) jeweils ein Source-Muster und ein Drain-Muster sind, ein erstes Durchgangsloch (161) auf der ersten Zwischenisolierschicht (16) vorgesehen ist und das zweite leitfähige Muster (15) über den zweiten Verbindungsteil (152) in dem ersten Durchgangsloch (161) mit dem aktiven Schichtmuster (12) verbunden ist; und
wobei das Pixelelektrodenmuster (22) elektrisch mit dem ersten Musterteil (141) verbunden ist; und
das Bilden des Pixelelektrodenmusters (22) auf dem Dünnschichttransistor (10) umfasst:
Bilden einer Planarisierungsschicht (23) auf dem Dünnschichttransistor (10); und
Bilden eines Pixelelektrodenmusters (22) auf der Planarisierungsschicht (23);
wobei ein zweites Durchgangsloch (231) auf der Planarisierungsschicht (23) vorgesehen wird und das Pixelelektrodenmuster (22) über das zweite Durchgangsloch (231) elektrisch mit dem ersten Musterteil (141) verbunden wird; und
wobei das Source-Muster eine Source aufweist und das Drain-Muster einen Drain aufweist, wobei ein Abstand zwischen einer orthographischen Projektion der Source auf dem Basissubstrat und einer orthogonalen Projektion des Drains auf dem Basissubstrat 0 beträgt, **dadurch gekennzeichnet, dass**
sich die orthographische Projektion der Source auf dem Substrat und die orthogonale Projektion des Drains auf dem Substrat nicht überlappen.

5. Verfahren zur Herstellung eines Arraysubstrats nach Anspruch 4, wobei der Dünnschichttransistor (10) ferner eine zweite Zwischenisolierschicht (17) aufweist und die aktive Schichtstruktur (12), die Gate-Isolierschicht (13), das Gate-Muster (11), die zweite Zwischenisolierschicht (17), das erste leitfähige Muster (14), die erste Zwischenisolierschicht (16) und das zweite leitfähige Muster (15) in dieser Reihenfolge gestapelt sind.

6. Verfahren zur Herstellung eines Arraysubstrats nach Anspruch 4, wobei vor dem Bilden des Dünnschichttransistors auf dem Basissubstrat (21) das Verfahren ferner ein aufeinanderfolgendes Bilden eines Lichtabschirmungsschichtmusters (24) und einer Pufferschicht (25) auf dem Basissubstrat (21) umfasst.

7. Anzeigevorrichtung, ein Arraysubstrat nach einem der Ansprüche 1 bis 3 aufweisend.

## Revendications

1. Substrat de réseau, comportant un transistor à couches minces (10), dans lequel le transistor à couches minces (10) comporte :
un motif de grille (11),
un motif de couche active (12),
une couche d'isolation de grille (13) entre le motif de grille (11) et le motif de couche active (12),
un premier motif conducteur (14) comportant une première partie de motif (141) et une première partie de connexion (142),
un deuxième motif conducteur (15) comportant une deuxième partie de motif (151) et une deuxième partie de connexion (152),
une première couche d'isolation intermédiaire (16) entre la première partie de motif (141) et la deuxième partie de motif (151), et la première couche d'isolation intermédiaire (16) étant disposée sur la première partie de motif (141) et la deuxième partie de motif (151) étant disposée sur la première couche d'isolation intermédiaire (16), et
une couche de planarisation (23) sur le transistor à couches minces (10), dans lequel un premier trou traversant (231) est ménagé sur la couche de planarisation (23),
dans lequel le premier motif conducteur (14) et le deuxième motif conducteur (15) sont un motif de source et un motif de drain, respectivement, un deuxième trou traversant (161) est ménagé sur la première couche d'isolation intermédiaire (16), et le deuxième motif conducteur (15) est connecté au motif de couche active (12) par l'intermédiaire de la deuxième partie de connexion (152) dans le deuxième trou traversant (161),
le substrat de réseau comporte en outre :
un substrat de base (21), et
un motif d'électrode de pixel (22),
dans lequel le transistor à couches minces (10) et le motif d'électrode de pixel (22) sont disposés de manière séquentielle sur le substrat de base (21), et
le motif d'électrode de pixel (22) est électriquement connecté à la première partie de motif (141) à travers le premier trou traversant (231), et
dans lequel le motif de source comporte une source et le motif de drain comporte un drain, un espace entre une projection orthographique de la source sur le substrat de base et une projection orthogonale du drain sur le substrat de base est égal à 0, **caractérisé en ce que** la projection orthographique de la source sur le substrat et la projection orthogonale du drain sur le substrat ne se chevauchent pas.

2. Substrat de réseau selon la revendication 1, comportant en outre une couche de passivation (26) et un motif d'électrode commune (27) sur le motif d'électrode de pixel (22).

3. Substrat de réseau selon la revendication 1, comportant en outre :
un motif de couche d'écran à la lumière (24) et une couche tampon (25),
dans lequel le motif de couche d'écran à la lumière (24), la couche tampon (25) et le transistor à couches minces (10) sont empilés de manière séquentielle, et
dans lequel le transistor à couches minces (10) comporte une deuxième couche d'isolation intermédiaire (17), le motif de couche active (12), la couche d'isolation de grille (13), le motif de grille (11), la deuxième couche d'isolation intermédiaire (17), le premier motif conducteur (14), la première couche d'isolation intermédiaire (16) et le deuxième motif conducteur (15) dans cet ordre.

4. Procédé de fabrication d'un substrat de réseau, comportant de :
former un transistor à couches minces (10) sur un substrat de base (21), et
former un motif d'électrode de pixel (22) sur le transistor à couches minces (10),
dans lequel le transistor à couches minces comporte un motif de grille (11), un motif de couche active (12), une couche d'isolation de grille (13) entre le motif de grille (11) et le motif de couche active (12), un premier motif conducteur (14) comportant une première partie de motif (141) et une première partie de connexion (142), un deuxième motif conducteur (15) comportant une deuxième partie de motif (151) et une deuxième partie de connexion (152), et une première couche d'isolation intermédiaire (16) entre la première partie de motif (141) et la deuxième partie de motif (151), et la première couche d'isolation intermédiaire (16) étant disposée sur la première partie de motif (141) et la deuxième partie de motif (151) étant disposée sur la première couche d'isolation intermédiaire (16),
dans lequel le premier motif conducteur (14) et le deuxième motif conducteur (15) sont un motif de source et un motif de drain, respectivement , un premier trou traversant (161) est ménagé sur la première couche d'isolation intermédiaire (16), et le deuxième motif conducteur (15) est connecté au motif de couche active (12) par l'intermédiaire de la deuxième partie de connexion (152) dans le premier trou traversant (161), et
dans lequel le motif d'électrode de pixel (22) est électriquement connecté à la première partie de motif (141), et
la formation du motif d'électrode de pixel (22) sur le transistor à couches minces (10) comporte de :
former une couche de planarisation (23) sur le transistor à couches minces (10), et
former un motif d'électrode de pixel (22) sur la couche de planarisation (23),
dans lequel un deuxième trou traversant (231) est ménagé sur la couche de planarisation (23), et le motif d'électrode de pixel (22) est électriquement connecté à la première partie de motif (141) à travers le deuxième trou traversant (231), et
dans lequel le motif de source comporte une source et le motif de drain comporte un drain, un espace entre une projection orthographique de la source sur le substrat de base et une projection orthogonale du drain sur le substrat de base est égal à 0, **caractérisé en ce que** la projection orthographique de la source sur le substrat et la projection orthogonale du drain sur le substrat ne se chevauchent pas.

5. Procédé de fabrication d'un substrat de réseau selon la revendication 4, dans lequel le transistor à couches minces (10) comporte en outre une deuxième couche d'isolation intermédiaire (17), et le motif de couche active (12), la couche d'isolation de grille (13), le motif de grille (11), la deuxième couche d'isolation intermédiaire (17), le premier motif conducteur (14), la première couche d'isolation intermédiaire (16) et le deuxième motif conducteur (15) sont empilés dans cet ordre.

6. Procédé de fabrication d'un substrat de réseau selon la revendication 4, dans lequel, avant la formation du transistor à couches minces sur le substrat de base (21), le procédé comporte en outre de former un motif de couche d'écran à la lumière (24) et une couche tampon (25) de manière séquentielle sur le substrat de base (21).

7. Appareil d'affichage, comportant un substrat de réseau selon l'une quelconque des revendications 1 à 3.
